# EUROPEAN PATENT APPLICATION

(11) **EP 4 648 215 A1**
(43) Date of publication of application: **12.11.2025**
(21) Application number: 25174171.6
(22) Date of filing: 05.05.2025
(51) Int. Cl.: H01P 5/107, H01Q 15/00, H01Q 21/00

(54) **CONTACTLESS INTERCONNECTION BETWEEN PCB AND ANTENNA ASSEMBLY**

(30) Priority: 07.05.2024 SE 2450487
(71) Applicant: Gapwaves AB, 41263 Göteborg (SE)
(72) Inventor: BENCIVENNI, Carlo, 412 62 Göteborg (SE); VOSOOGH, Abbas, 417 61 Göteborg (SE)
(74) Representative: Lind Edlund Kenamets Intellectual Property AB

(57) **Abstract**

The present disclosure relates to an antenna arrangement (10) comprising a PCB (1) a plurality of solder balls (16) soldered on the first major surface (1a) of the PCB (1), the PCB (1) further comprising a conductive layer (12a) connecting the solder balls (16) at their bases. The antenna arrangement further comprises an antenna module (2) comprising a second major surface (2b) which is electrically conductive and at least one waveguide opening (23) and at least one antenna aperture (22), wherein the antenna module (2) is arranged with the second major surface (2b) facing the PCB (1). The solder balls (16) are arranged to form an EBG structure together with the conductive second major surface (2b) of the antenna module (2) and the conductive layer of the first major surface (1a) of the PCB (1), and the antenna arrangement (10) further comprises a transmitting and/or receiving component (3).

## Description

### TECHNICAL FIELD OF THE INVENTION

The present invention relates to an antenna arrangement, featuring a contactless interconnection between a PCB and an antenna module.

### BACKGROUND OF THE INVENTION

Many types of wireless systems for communication or radar implementations includes a PCB and an antenna. Especially within the field of automotive, radar or communication systems with a PCB and antenna is used extensively since it generally enables compact systems which can be integrated into automobiles.

The PCB carries simple transmitters and/or receivers arranged on the PCB substrate (e.g. the transmitters and/or receivers are realized as patch antennas) and the PCB is arranged to communicate with an antenna module which guides electromagnetic waves to/from the PCB into the environment. The antenna is crucial since it generally is not possible to obtain the desired antenna patterns (in terms of directivity, side-lobe levels etc.) using only the transmitters and/or receivers that can be integrated into the PCB.

However it is challenging to obtain a low loss transition between the PCB integrated transmitter and/or receiver and the antenna to prohibit electromagnetic signals from leaking from the transition. High transition losses are detrimental for the efficiency of the wireless system and leakage signals risk damaging, or interfering with, other sensitive equipment in the surroundings of the wireless system.

To this end, different solutions have been presented for achieving a good electrical contact between the PCB and the antenna module to completely seal-off the transition. However, achieving good electrical contact may be challenging and to this end there is a need for a new and improved transition which overcomes at least some of these drawbacks.

### GENERAL DISCLOSURE OF THE INVENTION

It is a purpose of the present invention to overcome at least some of the drawbacks of prior solutions for providing a transition between a PCB and an antenna module.

According to a first aspect of the invention there is provided an antenna arrangement comprising a printed circuit board, PCB, having a first major surface and an opposite second major surface. The PCB further comprises a plurality of solder balls soldered on the first major surface of the PCB, the PCB further comprising a conductive layer connecting the solder balls at their bases. The antenna arrangement further comprises an antenna module having a first major surface and an opposite second major surface, wherein the second major surface is electrically conductive and comprises at least one waveguide opening. The first major surface comprises at least one antenna aperture communicating with the waveguide opening for transmitting or receiving electromagnetic waves of an operation wavelength λ, wherein the antenna module is arranged with the second major surface facing the first major surface of the PCB. The solder balls are arranged to form an electromagnetic band gap, EBG, structure together with the conductive second major surface of the antenna module and the conductive layer of the first major surface of the PCB, and wherein the EBG structure delimits a waveguiding space. The antenna arrangement further comprises a transmitting and/or receiving component arranged on the PCB in the waveguiding space or arranged on the PCB so as to communicate with the waveguiding space.

Hereby, solder balls which can be efficiently and accurately soldered directly onto a PCB are used to form the waveguiding space defining the transition from the PCB to the antenna module. Typically, solder balls are used to form a direct electric contact between two components. However, it has surprisingly been found that solder balls soldered onto a PCB can form an electromagnetic band gap (EBG) structure which efficiently stops electromagnetic propagation between the PCB and antenna module even if the solder balls are not directly contacting the conductive layer of the antenna module. To this end, the first aspect of the invention both achieves excellent transition performance in terms of low losses and low leakage while at the same time not necessitating direct electrical contact between the antenna module and the PCB. By not requiring direct electrical contact with the antenna module this makes assembly of the antenna arrangement much easier and tolerant for manufacturing errors (such as a varying gap for different solder balls and/or specimens of the antenna arrangement).

In some implementations, the transmitting and/or receiving component is arranged on the second major surface of the PCB and communicates with the waveguiding space through at least one throughgoing opening extending through the PCB.

Hereby, with the transmitting and/or receiving component on the second major surface of the PCB, the PCB can be placed very close to the antenna module allowing the antenna arrangement to be made more space efficient.

The inner surface of the throughgoing opening may be metalized so as to form a plated through hole (PTH). However, it is also envisaged that the throughgoing opening is not metalized. For example, the thoroughgoing opening could be realized as a drilled opening extending through the entire PCB.

A further benefit of arranging the transmitting and/or receiving component on the second major surface is that the transmitting and/or receiving component becomes exposed on the second major surface of the PCB allowing e.g. a cooling arrangement to contact the transmitting and/or receiving component and cool it. In some implementations, the transmitting and/or receiving component is a downwards-firing component, the downwards-firing component comprising an attachment side for attachment against the PCB and being configured to transmit and/or receive electromagnetic signals to/from the attachment side.

Alternatively, in some implementations, the transmitting and/or receiving component is arranged on the first major surface of the PCB in the waveguiding space.

With this design, the transmitting and/or receiving component is housed between the PCB and the antenna module which could contribute to achieving very low leakage levels. In some cases this design can also be more compact since the transmitting and/or receiving component does not protrude from the second major surface of the PCB.

In some implementations, the transmitting and/or receiving component is mounted to the PCB using soldering elements.

The soldering elements may be connected to a second conductive layer arranged on the opposite side of a substrate layer from the first conductive layer. The transmitting and/or receiving component may then transmit or receive signals via the soldering elements acting as both mechanical attachment and electrical communication channels for the transmitting and/or receiving component.

In some implementations, each of the soldering elements has a diameter which is smaller than the diameter of the solder balls.

To realize an effective EBG structure the solder balls will generally be of a different size compared to the soldering elements. For example, the solder balls have a transverse diameter which is larger (e.g. at least 20% larger, or at least 50% larger) than a transverse diameter of the soldering elements used to connect and/or mount the transmitting and/or receiving component.

In some implementations, the soldering elements are connected to individual conductors, the individual conductors being isolated from each other.

Using different isolated conductors the transmitting and/or receiving component can convey information to/from other devices arranged on the PCB or connected to the PCB. Hereby the soldering elements are distinct from the solder balls due to the soldering elements being of a different size (e.g. smaller) than the solder balls and/or due to the way the solder elements are connected, wherein the solder elements are isolated from each other, and the solder balls are electrically connected together at their bases.

In some implementations, the antenna module is arranged with the second major surface facing the first major surface of the PCB such that there is a gap, G, between at least one solder ball of the plurality of solder balls and the conductive second major surface of the antenna module.

Since the EBG structure formed by the solder balls soldered onto the PCB is effective even if one or more solder ball(s) is not in direct contact with the antenna module. In some implementations, at least one solder ball, a plurality of solder balls, at least a majority of the solder balls or all solder balls are separated from the antenna module with the gap G The gap G may vary from one solder ball to another solder ball and while one solder ball may be contacting the conductive layer of the antenna module another solder ball may be separated from the conductive layer of the antenna module with the gap G. The gap may be an air filled gap.

In some implementations, the gap G between the second major surface of the antenna module and the at least one solder ball is less than λ divided by four, less than λ divided by eight or less than λ divided by ten.

The EBG structure formed by the solder balls is comparatively tolerant for a varying gap size, allowing the gap to e.g. vary from solder ball to solder ball with maintained performance. Even though the air gap is larger for some solder balls compared to other solder balls (e.g. as a result of the PCB or antenna module bending or flexing) the isolation properties of the electromagnetic band gap structure are still excellent. In some implementations, the gap G is at least λ divided by 50, at least λ divided by 40, or at least λ divided by 30.

In some implementations, the solder balls are cored solder balls comprising a core coated with a solder material.

Cored solder balls are typically used for their mechanical strength to solder two electrical components together while keeping a predetermined separation distance between the two components. For example, soldering a heavy component onto a PCB using traditional soldering may mean that heavy component comes to rest directly on the PCB whereby cored solder balls provides mechanical support for holding the heavy component at a predetermined separation distance from the PCB while providing electrical contact.

Here, the cored solder balls are used to provide a more accurate electromagnetic band gap structure for facilitating lower losses and leakage.

In some implementations, the first major surface of the PCB comprises a solder mask layer, the solder mask layer having a plurality of apertures corresponding to the locations of the solder balls.

The solder mask layer allows the solder balls to be placed in an efficient manner well suited for mass production. Since the solder mask layer can be made thin it does not impede the transition properties despite it being present inside the waveguiding space. Typically, when designing waveguide transitions only metal surfaces are desired at the inner surfaces of the waveguide to provide low losses. However, it has been realized that a thin solder mask layer does not substantially degrade the performance allowing the solder balls to be attached using a solder mask technique, which is efficient and well suited for mass production.

In some implementations, the transmitting and/or receiving component is arranged on the second major surface of the PCB and communicates with the waveguiding space using at least one throughgoing opening wherein the at least one waveguide aperture in the antenna module is transversely offset from the at least one throughgoing opening wherein the waveguiding space extends transversely, between the conductive second major surface of the antenna module and the conductive layer of the first major surface of the PCB.

Hereby, transverse routing of electromagnetic signals can be performed in the waveguiding space between the PCB and the antenna module whereby this transverse routing does not need occur only in the antenna module which allows the antenna module to be made much thinner (i.e. having a smaller maximum thickness).

The antenna module may for example be realized as a single metal layer having a very small thickness (e.g. 1 mm or less) and no transverse routing capabilities. This allows the antenna arrangement to be made exceptionally thin and light, comprising only the PCB and a thin metal layer acting as the antenna module.

For example, the antenna module has a maximum thickness that is less than 2λ, less than λ, less than λ divided by two or less than λ divided by three. In some cases the antenna module may be even thinner, having a maximum thickness of less than lambda divided by four.

In some implementations, wherein the solder mask layer further comprises an elongated opening extending between the solder balls defining the transversely extending waveguiding space.

By providing an elongated opening in the solder mask layer generally following the transversely extending waveguiding space the transmission through the waveguiding space is enhanced since the metal of the conductive layer is exposed inside waveguiding space.

In some implementations, the antenna module comprises multiple layers, wherein each layer is made of metal or made of a non-metal material coated with a metal.

While a single layer antenna module is advantageous in terms of providing a very thin antenna arrangement the antenna module can of course also comprise a plurality of layers, wherein each individual layer is either a metal layer or a non-metal layer coated with a metal. A multi-layer antenna module may still be made compact and may offer enhanced antenna properties.

An antenna module comprising one or more individual layers is advantageous since it can be made very thin. In many applications, there is limited space available for the antenna module since there is limited clearance between the PCB and e.g. a protective casing into which the antenna arrangement is to be integrated. Since each layer of the one or more layers making up the antenna module can be made very thin the antenna module can be made very compact. Each layer may be seen as a two dimensional structure realized as a sheet extending in a transverse plane and having a thickness in the normal direction perpendicular to the transverse plane. Any structure provided on the sheet involves a variation in thickness or provision of throughgoing openings. The thickness variation is typically between about 30% and 100% of a maximum layer thickness (which e.g. is about 1 mm). By comparison, a three dimensional antenna module may comprise channels extending also in the transverse plane.

Hereby, antenna modules comprising at least one two dimensional layer may be preferred since it facilitates a more compact antenna module.

In some implementations, the antenna module is made of a non-metal material and coated with a metal.

For example, the antenna module may be made as a single piece using an injection molding technique and/or a 3D printing technique.

In some implementations, the solder balls have been formed using reflow soldering.

Reflow soldering is highly suitable for mass production meaning that it is a great advantage that this process can be used to form the solder balls.

In some implementations, a diameter of each solder ball is between λ divided by six and λ divided by three.

In some implementations, a transverse separation distance between each solder ball is at least λ divided by six.

This diameter and/or spacing of solder balls have shown to exhibit a high performance electromagnetic band gap structure which reduces losses and leakage. In some implementations the solder balls are arranged in a regular pattern or in a random pattern.

In some implementations, the PCB comprises a mounting feature configured to align with a mounting feature on the antenna module, wherein the antenna arrangement further comprises a plurality of solder balls soldered to the first major surface of the PCB around the mounting feature.

The mounting feature on the PCB may be one of an opening and a protrusion and similarly the mounting feature on the antenna module may be one of an opening and a protrusion. For example, the both the PCB and the antenna module comprises an opening as the mounting feature whereby the PCB and antenna module are held together using a screw, rivet or similar extending through the two openings. By providing solder balls of the exact same type as used to form the EBG structure around the mounting feature (openings) it is possible to establish a uniform distance between the PCB and the antenna module. Additionally, it is envisaged that multiple solder balls are distributed over the first main surface of the PCB to help maintaining the constant separation distance.

### BRIEF DESCRIPTION OF THE DRAWINGS

Aspects of the present invention will be described in more detail with reference to the appended drawings, showing embodiments of the present invention.
Figure 1 is a cross-sectional view of an antenna arrangement with a three dimensional antenna module according to some implementations.
Figure 2 is a cross-sectional view of an antenna arrangement with a single metal layer acting as the antenna module according to some implementations.
Figure 3a is a cross-sectional closeup view of the solder balls arranged on the first major surface of the PCB according to some implementations.
Figure 3b is a graph showing a dispersion diagram for an infinite periodic EBG unit cell.
Figures 4a-b are cross-sectional views illustrating how cored solder balls are attached to the first major surface of the PCB using reflow soldering.
Figure 5 is a cross-sectional view of an antenna arrangement with transmitting and/or receiving component arranged on the first major surface of the PCB, according to some implementations.
Figure 6a-c illustrates top-down views of the first major surface of the PCB according to some implementations.
Figure 7 illustrates the second major surface of the PCB according to some implementations.

### DETAILED DESCRIPTION OF CURRENTLY PREFERRED EMBODIMENTS

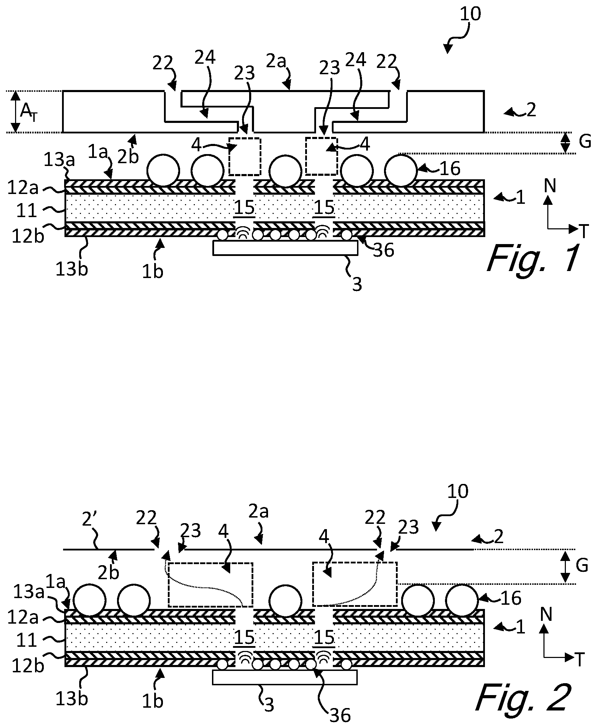

Fig. 1a shows an antenna arrangement 10 according to some implementations. The antenna arrangement 10 comprises a printed circuit board, PCB, 1, an antenna module 2 and a transmitting and/or receiving component 3 attached to the PCB 1.

The PCB 1 and the antenna module 2 both extend in parallel transverse T planes but are separated from each other in a normal direction N. The normal direction N being perpendicular to the transverse T planes.

The PCB 1 comprises multiple layers 11, 12a, 12b, 13a, 13b and in the embodiment shown in fig. 1 the PCB 1 comprises a central substrate layer 11 and a first and second conductive layer 12a, 12b arranged on a first side and opposite second side of the substrate layer 11, so as to form a layered structure together with the central substrate layer 11. The substrate layer 11 may be made of a dielectric material and the first and second conducive layers 12a, 12b may be made of a metal, such as copper. The PCB 1 further comprises a first and second solder mask layer 13a, 13b (sometimes referred to as simply a "solder mask") arranged on the first and second conductive layers 12a, 12b respectively, so as to form a sandwich structure comprising (from top to bottom): the first solder mask layer 13a, first conductive layer 12a, central substrate layer 11, second conductive layer 12b and the second solder mask layer 13b.

The PCB 1 of fig. 1 is merely exemplary and it is envisaged that the PCB 1 may comprise additional layers. For example, as is as such known in the art, PCBs 1 may be realized with multiple conductive layers and substrate layers sandwiched together to form a single multi-layer PCB 1. For the purposes of the present invention, the PCB 1 may be the PCB 1 as shown in fig. 1 or any other type of PCB 1 as long as there is at least one first conductive layer 12a.

The PCB 1 comprises a first major surface 1a and an opposite second major surface 2a. In fig. 1 the majority of the first major surface 1a is covered by the solder mask layer 13a however both the first conductive layer 12a and the first solder mask layer 13a are associated with the first major surface 1a and the second conductive layer 12b and the second solder mask layer 13b are associated with the second major surface 1b.

The first major surface 1a of the PCB 1 faces the antenna module 2. The antenna module 2 similarly comprises a first major surface 2a and an opposite second major surface 2b. The antenna module 2 comprises at least one waveguide opening 23 arranged in the second major surface 2b of the antenna module 2 and at least one antenna opening 22 arranged in the first major surface 2a of the antenna module 2. Each waveguide opening 23 is electromagnetically coupled to at least one antenna opening 22 so as to guide electromagnetic waves of an operation wavelength λ to/from the waveguide opening 23 from/to the at least one associated antenna opening 22.

In fig. 1, the antenna module 2 is realized as a three-dimensional component with a waveguide 24 electromagnetically connecting the at least one antenna opening 22 to the waveguide opening 23. Here, the antenna module 2 has a transverse thickness A_{T}. For example, the waveguide 24 inside the antenna module 2 may be a rectangular waveguide or similar. The antenna module 2 may e.g. be realized from one or more layers of a non-metal material which have been assembled and metallized to form the desired waveguide 24.

The antenna module 2 may be made of multiple metal layers assembled together or multiple non-metal layers coated with a metal. As a further example, the antenna module 2 may be two-dimensional and realized as a flat sheet e.g. the antenna module 2 may be realized as a single metal layer to realize an antenna module with very small transverse thickness A_{T}, as described in connection to fig. 2.

The antenna module 2 is generally designed so as to route electromagnetic signals to/from waveguide openings 23 to the antenna openings 22 so as to achieve desired antenna properties e.g. in terms of directivity, gain, sidelobe level etc. To accomplish this, multiple antenna openings 22 may be provided in the first major surface 2a of the antenna module 2 to form an array antenna. An array antenna can be used to obtain many types of antenna patterns while being flat, space efficient and suitable for integration into the active safety systems or communication systems of automobiles.

The second major surface 2b of the antenna module 2 faces the first major surface 1a of the PCB 1. Hereby, the antenna module 2 and the PCB 1 are arranged on top of each other to form a generally flat package. However, the antenna module 1 and the PCB 1 are not necessarily in physical or electrical contact with each other as will be described below.

The second major surface 2b of the antenna module 2 comprises a conductive layer facing the first major surface 1a of the PCB 1 which comprises the first conductive layer 12a (optionally underneath a solder mask layer 13a). For example, the antenna module 2 is a made of a non-metal material and metallized (i.e. coated with a metal) whereby the metal coating of the antenna module 2 faces the first side 1a of the PCB 1. Hereby, the conductive layer of the second major surface 2b of the antenna module may be the outermost layer of the antenna module 2.

Turning back to the PCB 1, the PCB 1 further comprises a plurality of solder balls 16 arranged on the first major surface 16 of the PCB 1. The solder balls 16 are hereby arranged to face the second major surface 2b of the antenna module 2. The solder balls 16 may contact the second major surface 2b of the antenna module 2 or be separated from the second major surface 2b of the antenna module.

Notably, none of the solder balls 16 is mechanically attached to the antenna module by soldering, adhesive, welding or otherwise.

In some implementations, the antenna module 2 is arranged with separation distance from the PCB 1 forming an air filled gap G between the tips of one or more solder balls 16 and the conductive layer of the second major surface 2b of the antenna module 2.

For operation frequencies in the range of 70 - 110 GHz, i.e. operation wavelengths λ in the range from about 4.2 mm to about 2.7 mm, the gap G may be less than 400 micrometers, such as between 100 and 400 micrometers. In some implementations, the gap G is between λ divided by 40 and λ divided by 7. For example the gap G is between λ divided by 40 and λ divided by 8, or λ divided by 30 and λ divided by 8. In some implementations, the gap G is at least λ divided by 50, at least λ divided by 40 or at least λ divided by 30. The gap G may be different for the solder balls 16. For example, one solder ball 16 may be separated from the antenna module 2 with a comparative large gap, while another solder ball 16 is separated from the antenna module with a comparatively small gap and while yet another solder ball 16 contacts the antenna module 2 and features no gap. In some implementations, each solder ball 16 either contacts the antenna module or features an individual gap G of less than λ divided by four.

The gap G is advantageously less than λ divided by four and more advantageously less than λ divided by eight.

Hereby, regardless of the solder balls 16 contacting the antenna module 2 or if there is a gap G between the solder balls 16 and the antenna module 2 it has been realized that solder balls 16 may be arranged to form an electromagnetic band gap (EBG) structure (often referred to as a metasurface) which prevents electromagnetic signals at or around the operation wavelength λ from escaping transversely between the second major surface 2b of the antenna module 2 and the first major surface 1a of the PCB 1. The solder balls 16, the conductive layer 12a of the first major surface 1a of the PCB 1 and the conductive layer of the second side 2b of the antenna module 2 hereby cooperate to form a waveguiding space 4 between the antenna module 2 and the PCB 1.

The waveguiding space 4 is delimited in the normal direction N (i.e. in a direction perpendicular to the transverse main surfaces of the PCB 1 and antenna module 2) by the conductive layer of the antenna module 2 on one hand and the conductive layer 12a of the PCB 1 on the other hand, and delimited in the normal direction N (i.e. in a direction parallel with the main surfaces 1a, 2b of the PCB 1 and antenna module 2) by the solder balls 16. Despite there in some implementations being an air gap G between one or more of the solder balls 16 and the antenna module 2, it has been found that the solder balls 16 form a stopband which prevents electromagnetic signals from leaking out from the waveguiding space 4 in the transverse direction between the PCB 1 and the antenna module 2. Advantageously, two or more rows of solder balls 16 are soldered on each transverse side of the waveguide space 4 to facilitate leakage protection.

Hereby, by changing the pattern with which the solder balls 16 are soldered on the PCB 1 it is possible to shape the waveguiding space 4 as desired.

The antenna arrangement 10 further comprises a transmitting and/or receiving component 3. A transmitting and/or receiving component 3 as such is well known in the art and is sometimes referred to as a Launcher-in-Package (LiP) or launching chipset despite these packages/chips being configured for receiving signals, transmitting signals or both. The transmitting and/or receiving component 3 comprises at least one communication element, the communication element comprising a receiver and/or a transmitter configured to receive and/or transmit electromagnetic signals at the operation wavelength λ. Typically, the transmitting and/or receiving component 3 comprises an attachment side and an opposite outer side, wherein the transmitting and/or receiving component 3 is configured to be mounted onto the PCB 1 with the attachment side facing the PCB 1 and the opposite outer side facing away from the PCB 1. On the attachment side, the transmitting and/or receiving component 3 comprises a plurality of terminals configured to be connected to the PCB 1 using soldering elements 36.

The transmitting and/or receiving component 3 thereby becomes electrically connected to the second conductive layer 12b of the second major surface 1b of the PCB 1 via the one or more soldering elements 36. The soldering elements 36 may be solder balls or other types of soldering. Typically, the soldering elements 36 of the transmitting and/or receiving component 3 will be different from the solder balls 16. For example, the solder balls 16 acting as an EBG structure will generally be larger than the solder elements 36 of the transmitting and/or receiving component 3.

The transmitting and/or receiving component 3 may be a bottom-firing component or a top firing component. In fig. 1 the transmitting and/or receiving component 3 is a bottom-firing component whereby its communication element is configured to emit and/or receive electromagnetic signals via its attachment side. The transmitting and/or receiving component 3 is soldered to the second side 1b of the PCB 1 and configured to convey electromagnetic signals from the transmitting and/or receiving component 3 to the waveguiding space 4. To allow electromagnetic signals travel to/from the waveguiding space 4 the PCB 1 comprises at least one throughgoing opening 15 aligned with the communication element of the transmitting and/or receiving component 3 whereby the throughgoing opening 15 guides electromagnetic signals to/from the waveguiding space 4 from/to the transmitting and/or receiving component 3.

The at least one throughgoing opening 15 extends through all layers of the PCB 1. For example, the throughgoing opening 15 is a drilled or stamped channel extending through the PCB 1.

Advantageously, the throughgoing opening 15 is metallized to facilitate efficient guiding of electromagnetic signals through the PCB 1. Hereby, the throughgoing opening 15 may be a so called plated through hole (PTH). To create a metallized throughgoing opening 15 the inner walls of the throughgoing opening 15 are metallized and the metallization layer provided on the inside of the throughgoing opening 15 may further be connected to the conductive layer 12a of the first side of the PCB 1. Hereby, electromagnetic signals can be conveyed between the transmitting and/or receiving component 3 and the waveguiding space 4 via the at least one throughgoing opening 15, whereby the electromagnetic signals are further routed to the waveguide openings 23 of the antenna module via the waveguiding space 4 formed between the PCB 1 and the waveguiding module.

In some implementations, the thoroughgoing opening 15 is not metallized. Depending on e.g. the operational wavelength λ and the thickness and/or type of PCB 1 used it is envisaged that a non-metallized throughgoing opening 15 suffices for providing communication between the waveguiding space 4 and the transmitting and/or receiving component 3.

Additionally, since the outer side of the transmitting and/or receiving component 3 faces away from the PCB 1 it is possible to connecting the outer side of the transmitting and/or receiving component 3 to a cooling arrangement for cooling the transmitting and/or receiving component 3.

Turning to fig. 2, an alternative embodiment of the antenna arrangement 10 is shown. The embodiment of fig. 2 comprises generally the same PCB 1 and transmitting and/or receiving component 3 as the embodiment of fig. 1 however, in fig. 2, the three-dimensional antenna module 2 of fig. 1 has been replaced with a single metal layer 2' acting as the antenna module 2. The metal layer 2' comprises at least one opening 22, 23 acting as both the waveguide opening 23 and the antenna opening 22.

With the three-dimensional antenna module 2 of fig. 1 it is possible to route the electromagnetic signals both along the normal direction N and transversely as desired to realize the desired antenna pattern with one or more antenna apertures 22. However, when an antenna module 2' consisting of a single metal layer 2' is used any transverse routing can no longer take place inside the antenna module. Hereby, the solder balls 16 are arranged to delimit a waveguiding space 4 which extends transverse between the antenna module layer 2' and the thoroughgoing opening 15 of the PCB 1 to realize any transverse signal routing between the PCB 1 the antenna module 2 instead of inside the antenna module.

The single metal layer 2' forming the antenna module 2 may have a thickness A_{T} of less than 400 um, less than 200 um or less than 100 um. For example, the metal layer 2' is a copper layer, aluminum layer or brass layer.

While a single metal layer 2' acting as the antenna module 2 allows the antenna module (and by extension the entire antenna arrangement 10) to be made very thin it is also envisaged that a multi-layer antenna arrangement could also be used. While a multi-layer antenna arrangement will generally add to the thickness of the antenna arrangement 10 in the normal direction N a multi-layer antenna arrangement will allow for sophisticated routing and antenna properties.

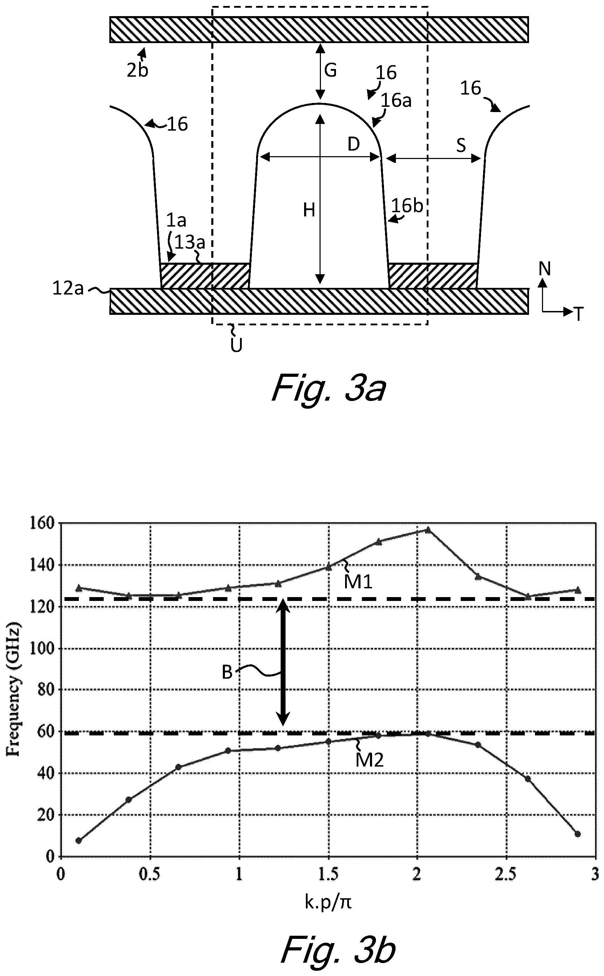

With reference to fig. 3a, a cross-section of three solder balls 16 is shown. To act as an efficient EBG structure the solder balls 16 advantageously has a diameter D in the range of the λ divided by 7 and λ divided by 2, for example each solder ball 16 has a diameter D between λ divided by 6 and λ divided by 3. In some implementations, the diameter D of the solder balls 16 is between 700 micrometer and 1000 micrometer which highly suitable for frequencies about 77 GHz. While it is possible to use larger solder balls (for longer operational wavelengths) there is in general a desire to keep the antenna arrangement as small as possible whereby larger solder balls may be avoided. Additionally, while it is possible to use smaller solder balls (for shorter operational wavelengths) this is sometimes also undesired since the manufacturing accuracy is limited and it becomes more costly to manufacture the solder balls 16.

The separation distance S between neighboring solder balls 16 is preferably in the range of λ divided by 6 to λ divided by 4. It is envisaged that the solder balls 16 may be placed with regular separation distances S or even randomly, with separation distances ranging between λ divided by 6 to λ divided by 4. Advantageously, at least two transversely displaced rows of solder balls 16 are used to transversely delimit any waveguiding space.

Each solder ball 16 has a height H to which it extends above the first conductive layer 12a of the PCB which is in the range of the λ divided by 7 and λ divided by 2, for example each solder ball 16 has a heigh H between λ divided by 6 and λ divided by 3. In some implementations, the conductive layer 12a is covered with a solder mask layer 13a whereby each solder ball is connected to the conductive layer 12a via an opening in the solder mask layer 13a. The solder mask layer 13a is typically very thin and may e.g. be between 10 and 30 micrometers such as about 20 micrometers. Hereby, the height H of each solder ball 16 is slightly smaller when measured from the outer surface of the solder mask layer compared to as measured from the first conductive layer 12a.

Additionally, the height H and diameter D of the solder balls 16 may be different from each other after the reflow soldering process. For example, solder material may emigrate from the top of the solder ball 16 to the bottom during soldering.

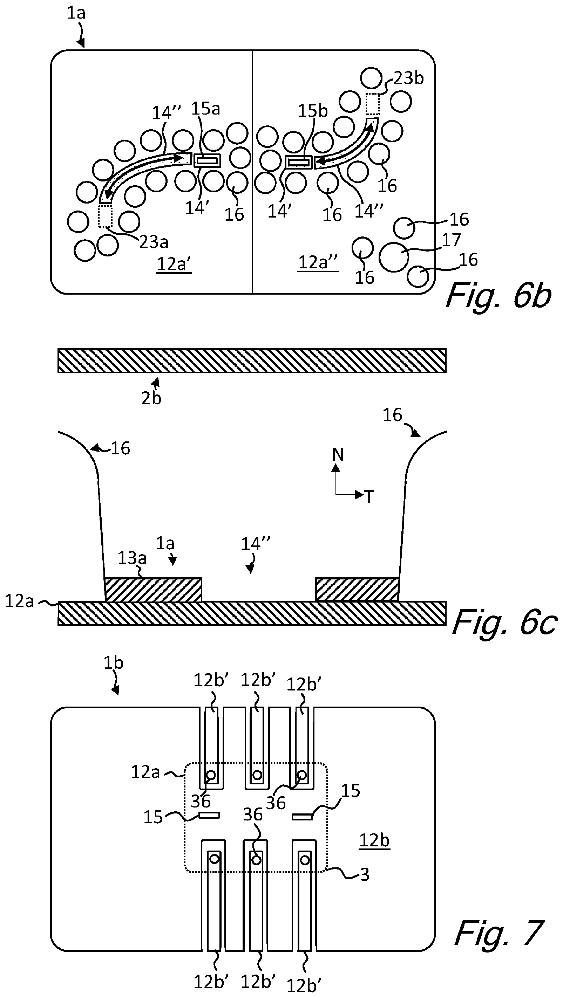

The solder balls 16 are all electrically connected at their bases via the first conductive layer 13a. In some implementations, the solder balls 16 are arranged in two or more separate groups, with each group of solder balls 16 forming a separate waveguiding space, and wherein at least the solder balls of each solder ball group are connected together via a common conductive layer of the PCB 1, as will be described below in connection to fig. 6b.

The gap G between one or more (or all)solder ball 16 and the conductive layer of the second major surface 2b of the antenna module may be less than λ divided by four. Of course, in some implementations there is no gap G for one or more solder balls 16 wherein these solder balls directly contact the conductive layer of the second major surface 2b of the antenna module.

Fig. 3b is a graph showing a dispersion diagram for an infinite periodic repetition of "unit cells" wherein each unit cell comprises a solder ball as shown in fig. 3a. More specifically, each unit cell comprises the components include in the dashed line box U in fig. 3a, namely a solder ball 16, the conductive layer 12a of the PCB in the vicinity of the solder ball 16, the solder mask layer 13a in the vicinity of the solder ball 16 and the conductive layer of the second surface 2b of the antenna module.

The horizontal axis of the dispersion diagram in fig. 3b shows the wavenumber k.p divided by π and the vertical axis is frequency in GHz. Line M1 represents the first order mode and line M2 represents the second order mode. As seen, there is a frequency band gap B between the two modes extending from about 60 GHz to about 125 GHz meaning that between these frequencies no electromagnetic mode can exist, and the repeating solder balls form a high impedance material which prohibits electromagnetic signals from propagating between the conductive layer 12a of the PCB and the conductive layer of the conductive second surface 2b of the antenna module.

Notably, the stopband B is obtained even when there is a non-zero gap G between the solder balls 16 and the second surface 2b of the antenna module. The unit cell used to obtain the dispersion diagram of fig. 3b features a gap G of 100 micrometer and a solder ball diameter of 800 micrometers.

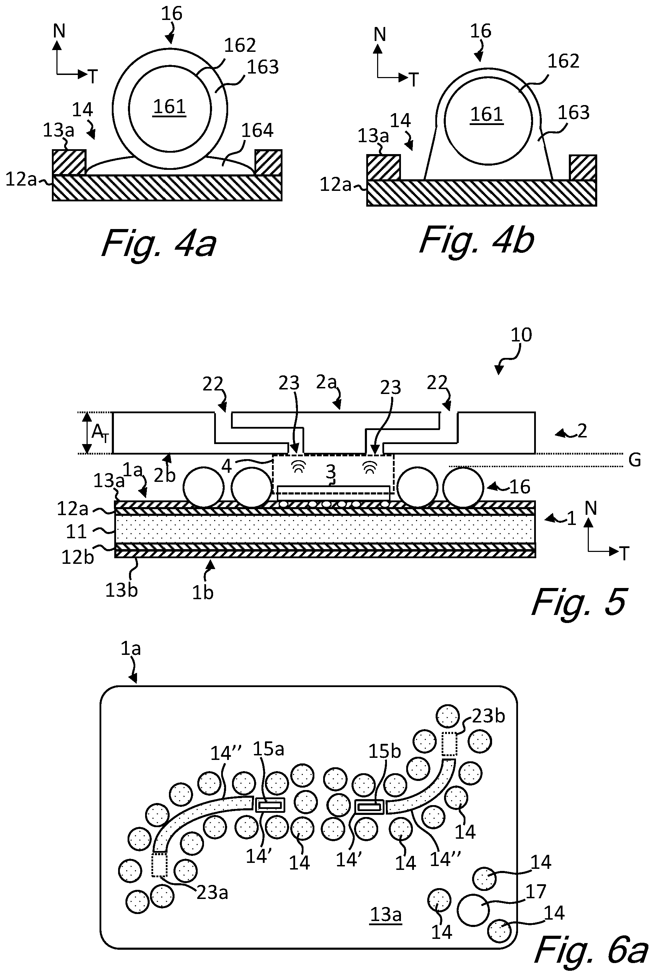

Additionally, it is noted that while the solder balls 16 may feature a rounded or generally dome shaped top portion 16a the solder balls may feature a cylindrical or frustoconical base portion 16b connecting the top portion 16a to the first conductive layer 12a. While the solder balls 16 are still referred to as solder balls this shape (with a cylindrical or frustoconical base portion 16b) is typical for solder balls as they appear after soldering, and e.g. after reflow soldering. One exemplary type of reflow soldering with so called "cored" solder balls 16 is illustrated in figs. 4a and 4b.

With reference to fig. 4a the solder mask layer 13a is provided on top of the first conductive layer 12a with a plurality of openings 14 through the solder mask layer 13a corresponding to the locations where solder balls 16 are to be arranged. In other words, the openings 14 through the solder mask layer 13a expose the conductive layer 12a of the PCB.

A solder ball 16 comprising a core 161 coated with a solder material 163 is then arranged in each opening through the solder mask layer 13a. Optionally, to keep the solder balls 16 in place prior to soldering the solder ball 16 is placed on a sticky flux material 164 which is provided in the opening 14 through the solder mask layer 13a. By subsequently heating the solder ball 16, the solder material 163 melts (and any flux 164 evaporates or mixes with the solder material 163) to partially flow of the core 161 onto the conductive layer 12a as shown in fig. 4b. The heating procedure is then stopped whereby the solder material 163 solidifies forming a solder ball 16 with an approximately cylindrical or frustoconical base portion as shown in fig. 4b.

The use of cored solder balls 16 as opposed to dots or beads of pure solder material allows the solder balls to be realized with more consistent and accurate dimensions, which facilitates better EBG properties. The material of the core 161 may e.g. be a non-metal material such as plastic or ceramic which does not melt at the melting point of the solder material 163. As another example the core 161 is made of a metal having a higher melting point compared to the solder material, such as copper. The solder material 163 could be any type of solder material, such as tin or gold-tin alloy.

In some implementations, to further enhance manufacturing accuracy and ensure that no part of the non-metal core 161 is exposed after reflow soldering, the core 161 may be provided with a metal coating 162. The metal coating is realized with a metal having a melting point exceeding that of the solder material 163, for example the metal coating 162 is realized with nickel.

Turning to fig. 5, another example of the antenna arrangement 10 is shown. This embodiment is generally similar to the embodiment of fig. 1, however, in fig. 5 the l transmitting and/or receiving component 3 has been placed on the first major surface 1a of the PCB 1 instead of on the second major surface of the PCB 1. The transmitting and/or receiving component 3 is here a top-firing component 3 which is attached to the first major surface 1a of the PCB 1 with the attachment side and configured to transmit and/or receive electromagnetic signals with the operation wavelength λ via a communication element on the outer side, into the waveguide openings 23.

Hereby, the transmitting and/or receiving component 3 may in some implementations be arranged inside the waveguiding space 4 formed by the solder balls 16 and the conductive layer of the antenna module 2 and the conductive layer 12a of the first major surface 1a of the PCB 1.

While figs. 1, 2 and 5 show antenna arrangements 10 with one transmitting and/or receiving component 3 and two waveguide openings 23 (and two throughgoing openings 15) it is of course possible to use two or more transmitting and/or receiving components 3 and/or use at least one transmitting and/or receiving component 3 wherein the at least one transmitting and/or receiving component 3 comprises two separate communication elements, each communication element comprising a transmitter and/or receiver and each communication element being configure to communicate with a separate throughgoing channel 15 of the PCB 1 and/or waveguide opening 23 of the antenna module 2.

Fig. 6a shows a top down view of the first major surface 1a of the PCB. A solder mask layer 13a is formed covering substantially the whole first major surface 1a of the PCB. A plurality of openings 14 are provided in the solder mask layer 13a so as to expose the conducive layer underneath. It is in these openings 14 where the solder balls are soldered so as to connect all solder balls together via the underlying conducting layer of the first major surface 1a. The openings 14 are hereby arranged so as to delimit one or more waveguide spaces 4a, 4b. In fig. 6a, two waveguiding spaces 4a, 4b are provided and in this embodiment, both waveguiding spaces 4a, 4b are elongated and extending in the transverse direction. The first waveguiding space 4a communicates with a first throughgoing opening 15a of the PCB and then extends transversely to the position where a first waveguiding opening 23a of the antenna module will be located, when the PCB is arranged together with antenna module. The second waveguiding space 4b communicates with a second throughgoing opening 15b of the PCB and extends transversely to the position where the second waveguiding opening of the antenna module will be located, when the PCB and the antenna module are arranged together to form the antenna arrangement. The two waveguiding spaces 4a, 4b are isolated from each other since they are separated by the arrangement of solder balls 16.

In some implementations, a transition area 14' on the first major surface 1a of the PCB surrounding the one or more throughgoing openings 15a, 15b is also devoid of solder mask layer 13a. That is the transition area 14' forms margin surrounding the throughgoing opening 15a, 15b wherein the conductive layer is exposed and not covered by the solder mask layer 13a. In this way, it is avoided that solder mask material enters into the throughgoing opening 15a, 15b. For example, the throughgoing opening 15a, 15b occupies less than 95%, less than 90% or less than 80% of the transition area 14' in which it is located so as to form a margin around throughgoing opening 15a, 15b.

Generally, however, it is preferable for solder balls to be located as close as possible to the throughgoing opening 15a, 15b to prevent leakage and losses.

The openings 14 formed in the solder mask layer 13a may also be formed at locations in vicinity to mounting features 17 on the PCB. To assemble the PCB and antenna module to an antenna arrangement the PCB and the antenna module may be provided with corresponding mounting features 17 to allow the two components to be held together using screws, rivets or similar. For example, the mounting feature 17 on the PCB is an opening configured to receive a screw and there is a corresponding opening on the antenna module whereby the two components can be held together using a screw and bolt. By soldering the same type of solder balls used to form the EBG structure also at the openings in the vicinity of the mounting feature 17, it is possible to achieve a very homogeneous and constant distance between PCB and the antenna module.

In some implementations, an elongated opening 14" is provided in the solder mask layer 13a wherein the elongated opening 14" is separate from any of the openings 14 associated with the solder balls. The elongated opening 14" extends inside and along each waveguiding space to expose the conductive layer underneath the solder mask layer 13a, as seen in fig. 6c. By exposing the conductive layer along the waveguiding space the transmission properties (e.g. in terms of losses and reflections for signals propagating along the waveguiding space) are improved.

In fig. 6b the solder mask layer has been removed showing the conductive layer underneath with the solder beads 16 soldered thereto. In this embodiment, the conductive layer comprises two portions, a first portion 12a' connecting all solder balls 16 of a first group of solder balls 16 and a second portion 12a" connecting all solder balls 16 of a second group of solder balls 16. The first and second portion 12a', 12a'' of the conductive layer may be electrically connected together or electrically isolated from each other. The first group of solder balls 16 delimits the first waveguiding space 4a and the second group of solder 16 balls delimits the second waveguiding space 4b and advantageously all solder balls 16 of each group are connected together. However, it is not necessary for any solder ball of the first group to be electrically connected with a solder ball of the second group, in fact, in some implementations where two or more separate waveguiding spaces 4a, 4b are provided it may be preferable to arrange each group of solder balls on a separate, electrically isolated, portions 12a', 12a" of the conductive layer of the PCB since this may improve signal isolation between the two waveguiding spaces 4a, 4b.

Additionally, solder balls 16 have also been soldered around the mounting feature 17. Hereby, solder balls 17 for forming the EBG structure as well as for facilitating the structural separation between the PCB and antenna module may be added in the same efficient process.

Fig. 7 shows the second side 2b of the PCB with the solder mask layer removed, exposing the second conductive layer 12b of the PCB. The contour of the transmitting and/or receiving component 3 is shown overlaying the one or more throughgoing openings 15 extending through the PCB to the waveguiding space defined between the first side 1a of the PCB and the second side of the antenna module. The transmitting and/or receiving component 3 will in some implementations be connected to other hardware provided on the PCB and/or connected to PCB terminals for connection to one or more external devices (e.g. signal processors). To this end, one more of the soldering elements 36 of the transmitting and/or receiving component are connected to one or more conductors 12b' wherein each conductor is isolated from each other conductor and the rest of the conductive layer 12b of the second side of the PCB. Hereby, it is possible for the transmitting and/or receiving component to communicate with other devices arranged on the PCB and/or with external devices connected to the PCB.

Turning back to fig. 1 it is now understood that the antenna arrangement 10 according to embodiments described herein can be made small and compact. Additionally, the antenna arrangement, while still being able to offer excellent antenna properties and low losses, is made of just two main parts: a PCB with a transmitting and/or receiving component and an antenna module. These two main parts can be manufactured in two separate and highly efficient processes.

There are many suitable processes for forming the antenna module. For example, the antenna module can be made with an injection molding process, realized as a multilayer antenna module or realized as a single metal layer. However, generally the antenna modules are too large to be able to undergo a reflow soldering process, whereby the solder balls are provided on the PCB.

The PCB with the transmitting and/or receiving component may be manufacturing using regular PCB manufacturing techniques. For example, the mounting of transmitting and/or receiving components (such as the transmitting and/or receiving component) to a PCB can be made using a variety of techniques. Additionally, while solder balls (such as cored solder balls as described in connection to fig. 4a, 4b) have been used for the mounting of transmitting and/or receiving components and can efficiently and be attached in large numbers to a PCB these have never before been used to form a waveguide together with an antenna module having a conductive layer.

It has been realized that despite the solder mask layer covering the conductive layer of the first side of the PCB this layer does not impede the performance of the waveguiding space formed between the antenna module and the conductive layer of the first side of the PCB.

Hereby, the antenna modules and PCB with one or more transmitting and/or receiving components can be manufactured fully in highly efficient manufacturing processes well suited for mass production and then arranged together to form the antenna module. Since the solder balls may be arranged with an air filled gap G to the second side of the antenna module the final assembly of these two components is further facilitated since it is not necessary to ensure any electric contact between the antenna module and the solder balls of the PCB.

The person skilled in the art realizes that the present invention by no means is limited to the preferred embodiments described above. On the contrary, many modifications and variations are possible within the scope of the appended claims. For example, the PCB could have additional layers as mentioned above, such as one or more additional conductive layers arranged between the first and second conductive layers discussed above.

Such and other obvious modifications must be considered to be within the scope of the present invention, as it is defined by the appended claims. It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting to the claim. The word "comprising" does not exclude the presence of other elements or steps than those listed in the claim. The word "a" or "an" preceding an element does not exclude the presence of a plurality of such elements.

## Claims

1. An antenna arrangement (10) comprising:
a printed circuit board (1), PCB, having a first major surface (1a) and an opposite second major surface (1b), the PCB (1) further comprising a plurality of solder balls (16) soldered on the first major surface (1a) of the PCB (1), the PCB (1) further comprising a conductive layer (12a) connecting the solder balls (16) at their bases,
an antenna module (2) having a first major surface (2a) and an opposite second major surface (2b), wherein the second major surface (2b) is electrically conductive and comprises at least one waveguide opening (23) communicating with at least one antenna aperture (22) arranged on the first major surface (2a) for transmitting or receiving electromagnetic waves of an operation wavelength λ, wherein the antenna module (2) is arranged with the second major surface (2b) facing the first major surface (1a) of the PCB (1),
wherein the solder balls (16) are arranged to form an electromagnetic band gap, EBG, structure together with the conductive second major surface (2b) of the antenna module (2) and the conductive layer of the first major surface (1a) of the PCB (1), and wherein the EBG structure delimits a waveguiding space (4), the antenna arrangement (10) further comprising:
a transmitting and/or receiving component (3) arranged on the PCB (1) in the waveguiding space (4) or arranged on the PCB (1) so as to communicate with the waveguiding space (4).

2. The antenna arrangement (10) according to claim 1, wherein the transmitting and/or receiving component (3) is arranged on the second major surface (1b) of the PCB (1) and communicates with the waveguiding space (4) through at least one throughgoing opening (15) extending through the PCB (1),
wherein optionally the transmitting and/or receiving component (3) is a downwards-firing component, the downwards firing component comprising an attachment side and being configured to transmit and/or receive electromagnetic signals from the attachment side.

3. The antenna arrangement (10) according to claim 1, wherein the transmitting and/or receiving component (3) is arranged on the first major surface (1a) of the PCB (1) in the waveguiding space (4).

4. The antenna arrangement (10) according to any of the preceding claims, wherein the transmitting and/or receiving component (3) is mounted to the PCB (1) using soldering elements (36).

5. The antenna arrangement (10) according to claim 4, wherein each of the soldering elements (36) has a diameter which is smaller than the diameter of the solder balls (16), and/or wherein the soldering elements are connected to individual conductors (12b'), the individual conductors (12b') being isolated from each other.

6. The antenna arrangement (10) according to any of the preceding claims, wherein the antenna module (2) is arranged with the second major surface (2b) facing the first major surface (1a) of the PCB (1) such that there is a gap, G, between at least one solder ball (16) of the plurality of solder balls (16) and the conductive second major surface (2b) of the antenna module (2), wherein optionally the gap G between the second major surface (2b) of the antenna module (2) and the at least one solder ball (16) is less than λ divided by four, less than λ divided by eight or less than λ divided by ten.

7. The antenna arrangement (10) according to any of the preceding claims, wherein the solder balls (16) are cored solder balls comprising a core (161) coated with a solder material (163).

8. The antenna arrangement (10) according to any of the preceding claims, wherein the first major surface (1a) of the PCB (1) comprises a solder mask layer (13a), the solder mask layer (13a) having a plurality of apertures (4') corresponding to the locations of the solder balls (16).

9. The antenna arrangement (10) according to any of the preceding claims,
wherein the transmitting and/or receiving component (3) is arranged on the second major surface (1b) of the PCB (1) and communicates with the waveguiding space (4) using at least one throughgoing opening (15),
wherein the at least one waveguide aperture (23) in the antenna module (2) is transversely offset from the at least one throughgoing opening (15) wherein the waveguiding space (4a, 4b) extends transversely, between the conductive second major surface (2b) of the antenna module (2) and the conductive layer of the first major surface (1a) of the PCB (1).

10. The antenna arrangement (10) according to claim 9, when depending on claim 8, wherein the solder mask layer (13a) further comprises an elongated opening (4") extending between the solder balls (16) defining the transversely extending waveguiding space (4a, 4b).

11. The antenna arrangement (10) according to any of the preceding claims, wherein the antenna module (2) is realized as a single metal layer, or
wherein the antenna module (2) comprises multiple layers, wherein each layer is made of metal or made of a non-metal material coated with a metal, or
wherein the antenna module (2) is made of a non-metal material and coated with a metal.

12. The antenna arrangement (10) according to any of the preceding claims, wherein the antenna module (2) has a maximum thickness that is less than 2λ, less than λ, less than λ divided by two or less than λ divided by three.

13. The antenna arrangement (10) according to any of the preceding claims, wherein the solder balls (16) have been formed using reflow soldering and/or wherein a diameter (D) of each solder ball (16) is between λ divided by six and λ divided by three.

14. The antenna arrangement (10) according to any of the preceding claims, wherein a transverse separation distance (S) between each solder ball (16) is at least λ divided by six.

15. The antenna arrangement (10) according to any of the preceding claims, wherein the PCB (1) comprises a mounting feature (17) configured to align with a mounting feature on the antenna module (2), wherein the antenna arrangement (10) further comprises a plurality of solder balls (16) soldered to the first major surface (1a) of the PCB (1) around the mounting feature (17).
